# EUROPÄISCHE PATENTSCHRIFT

(11) **EP 1 701 388 B1**
(45) Veröffentlichungstag und Bekanntmachung des Hinweises auf die Patenterteilung: **09.09.2009**
(21) Anmeldenummer: 05005252.1
(22) Anmeldetag: 10.03.2005
(51) Int. Cl.: H01L 33/00

(54) **Leuchtiode**
Light emitting diode
Diode électroluminescente

(43) Veröffentlichungstag der Anmeldung: 13.09.2006
(73) Patentinhaber: Nanogate Advanced Materials GmbH, 66287 Quierschied-Göttelborn (DE)
(72) Erfinder: Klenke, Martin, Dr., 66440 Blieskastel (DE)
(74) Vertreter: von Kreisler Selting Werner

(56) Entgegenhaltungen:
- EP-A- 1 115 155
- WO-A-02/07230
- WO-A-20/04044995
- PATENT ABSTRACTS OF JAPAN Bd. 004, Nr. 165 (E-034), 15. November 1980 (1980-11-15) & JP 55 113387 A (SANYO ELECTRIC ET AL), 1. September 1980 (1980-09-01)
- PATENT ABSTRACTS OF JAPAN Bd. 017, Nr. 453 (E-1417), 19. August 1993 (1993-08-19) & JP 05 102528 A (OMRON CORP), 23. April 1993 (1993-04-23)
- PATENT ABSTRACTS OF JAPAN Bd. 013, Nr. 110 (E-728), 16. März 1989 (1989-03-16) & JP 63 283174 A (OMRON CORP), 21. November 1988 (1988-11-21)
- GALE M T: "Replication techniques for diffractive optical elements" MICROELECTRONIC ENGINEERING, Bd. 34, 1997, Seiten 321-339, XP004108296 ISSN: 0167-9317

## Beschreibung

Die Erfindung betrifft eine Leuchtdiode (LED).

LEDs werden in einer Vielzahl von Vorrichtungen eingesetzt und sind heutzutage weit verbreitet. Je nach eingesetzten Materialien wird von der LED Licht in unterschiedlichen Farben sowohl im sichtbaren als auch im nicht-sichtbaren Bereich erzeugt. Diesem Lichterzeugungselement ist in Abstrahlrichtung ein Lichtleitkörper zugeordnet. Durch den zumeist aus Kunststoff bestehenden Lichtleitkörper wird der Abstrahlwinkel der LED festgelegt. Bei bekannten Lichtleitkörpern handelt es sich um refraktive Elemente, wie beispielsweise Linsen. Die durch refraktive Lichtleitkörper hervorgerufene Brechung des von dem Lichterzeugungselement abgegebenen Lichts führt dazu, dass keine gute Korrektur der Lichtabstrahleigenschaften möglich ist. Insbesondere ist keine gute Strahl-Kollimation möglich. Da es sich bei refraktiven Elementen insbesondere um Linsen handelt, die stets Randfehler aufweisen, erhöhen sich die Fehler bei einer Miniaturisierung der einzelnen Linsen, da eine Vielzahl kleiner Linsen mehr Randbereiche aufweist, als eine große Linse.

Aus EP 1 115 155 ist ein LED-Array bekannt, wobei jeder einzelnen LED entweder eine diffraktive Kollimatorlinse oder diffraktive Fokussierlinse zugeordnet ist. Die einzelnen LEDs sind in Löchern eines Silikonsubstrats angeordnet um Fehl-Ausrichtungen der einzelnen LEDs zu vermeiden.

Des Weiteren ist beispielsweise aus WO 2004/044995 das Vorsehen relativ grober diffraktiver Gitter auf einem Lichtleitkörper einer LED bekannt. Derartig große diffraktive Gitter sind jedoch relativ ungenau und für die Gewährleistung exakter Abstrahleigenschaften, beispielsweise hinsichtlich der Farbe und des Winkels nicht geeignet.

Aufgabe der Erfindung ist es, eine LED mit guten Abstrahleigenschaften zu schaffen.

Die Lösung der Aufgabe erfolgt erfindungsgemäß durch eine LED gemäß Patentanspruch 1.

Die erfindungsgemäße LED weist einen Grundkörper auf, der das Lichterzeugungselement, wie den LED-Chip, trägt. In Abstrahlrichtung des Lichterzeugungselementes ist ein Lichtleitkörper angeordnet. Erfindungsgemäß weist der Lichtleitkörper eine Vielzahl von diffraktiven Elementen auf, wobei die einzelnen Elemente eine Größe von 0,04 µm² bis 10.000 µm² aufweisen. Das Vorsehen von das Licht beugenden Lichtleitelementen hat den Vorteil, dass bei geringen Verlusten ein Abstrahlwinkel der LED auf einfache Weise festgelegt werden kann. Mit Hilfe des erfindungsgemäßen Vorsehens von diffraktiven Lichtleitelementen kann eine gute Korrektur der Lichtabstrahleigenschaften erfolgen. Insbesondere ist es möglich, eine gute Strahl-Kollimation zu realisieren. Da diffraktive Lichtleitelemente im Unterschied zu refraktiven Elementen keine Randfehler aufweisen, ist die erfindungsgemäße Miniaturisierung der einzelnen diffraktiven Lichtleitelemente bei guten Lichtabstrahleigenschaften möglich.

Die Ausgestaltung der Lichtleitelemente zur Einstellung der Abstrahlrichtung bzw. des Abstrahlwinkels des LED erfolgt durch entsprechende Ausgestaltung der in den Lichtleitelementen vorgesehenen Beugungsgitter. Hierbei kann die Beugungsstärke der Beugungsgitter mit Hilfe des Fraunhoferschen Beugungsgesetzes bestimmt werden.

Vorzugsweise sind die Lichtleitelemente an einer Oberfläche des Lichtleitkörpers angeordnet. Hierbei kann es sich um die in Richtung des Lichterzeugungselementes weisende oder die gegenüberliegende Oberfläche handeln. Ferner ist es möglich, Lichtleitelemente, wie Reflektoren und dgl., zwischen dem Lichterzeugungselement und dem Lichtleitkörper anzuordnen, so dass die mit den Lichtleitelementen versehene Oberfläche beispielsweise in Richtung des Reflektors weist.

Besonders bevorzugt ist es hierbei, die Lichtleitelemente mit Hilfe eines aushärtenden Lacks auf der Oberfläche des Lichtleitkörpers herzustellen. Hierzu wird vorzugsweise mit Hilfe einer Abformeinrichtung, in die das Negativ des Beugungsgitters beispielsweise durch lithographische Verfahren eingebracht ist, verwendet. Mit Hilfe einer einzigen Abformeinrichtung können vorzugsweise mehrere Lichtleitelemente abgeformt werden. Hierbei wird vorzugsweise ein aushärtender Lack verwendet, der mit dem Lichtleitkörper eine stärkere Verbindung eingeht als mit der Abformeinrichtung. Hierdurch ist sichergestellt, dass beim Entfernen der Abformeinrichtung eine exakte Oberflächenstruktur hergestellt wird.

Ein besonders bevorzugtes Herstellungsverfahren sowie ein geeignetes Material zur Herstellung der Lichtleitelemente ist in EP 05 003 358.8 beschrieben.

Als Material zur Herstellung der Obernächenelemente ist insbesondere geeignet:
11 g 1H,1H,2H,2H-Perfluoroctylacrylat wurden mit 8 g Dipropylenglykoldiacrylat, 0,1 g Irgacure® 819 und 0,2 g Irgacure® 184 der Firma Ciba Spezialitätenchemie Lampersheim GmbH vermischt. 60 µl dieser Mischung wurde auf eine 2 x 2 cm große Nickelplatte aufgebracht, auf deren Oberfläche eine Negativform eines Formkörpers mit Streuzentren ausgebildet ist. Anschließend wurde ein 1 mm dickes und 1 x 1 cm großes Plättchen aus PMMA auf Oberfläche der Mischung auf der Nickelplatte aufgebracht. Daraufhin wurde der so erhaltene Sandwich auf der Nickelplatte mit dem dazwischen befindlichen Gemisch für 2 Sekunden UV-Strahlung einer handlesüblichen UV-Quecksilberlampe ausgesetzt. Anschließend wurde das Substrat mit der damit verbundenen gehärteten Abformzusammensetzung von der Negativ-Gussform entnommen.

Um eine exakte Lage der einzelnen Lichtleitelemente auf der Oberfläche des Lichtleitkörpers definieren zu können, ist die mit den Lichtleitelementen versehene Oberfläche vorzugsweise eben.

Vorzugsweise sind die einzelnen Lichtleitelemente derart ausgebildet, dass sie als Beugungselemente wirken, die vorzugsweise ein kollimiertes Lichtbündel mit spektraler Lichtaufspaltung erzeugen. Hierzu weisen die einzelnen Lichtleitelemente vorzugsweise im Querschnitt wellenförmige Oberflächenstrukturen auf, wobei der Wellenabstand in Abhängigkeit der auszulenkenden Wellenlänge gewählt ist. Hierbei weisen vorzugsweise einzelne Lichtleitelemente unterschiedliche Beugungsgitter auf. Besonders bevorzugt ist es, dass die Lichtleitelemente derart angeordnet sind, dass durch Überlagerung von mindestens zwei benachbarten Lichtbündeln überwiegend monochromatisches Licht und/ oder weißes Licht entsteht. Hierbei wird unter monochromatischem Licht ein Wellenlängenbereich von 100 nm, insbesondere 50 nm verstanden. Durch das erfindungsgemäße Vorsehen derartiger Lichtleitelemente kann somit ein weitgehend monochromatisches und/ oder weißes, insbesondere kollimiertes Licht erzeugt werden.

Durch die Ausgestaltung der Oberfläche der Lichtleitelemente ist es ferner möglich, die Abstrahlrichtung des Lichts von der Austrittsoberfläche einzustellen. Hierzu ist das an den Oberflächenelementen vorgesehene Beugungsgitter entsprechend der Fraunhoferschen Beugungsgesetze zu modifizieren. Die Einstellbarkeit liegt hierbei vorzugsweise, im Bereich von 0 - 90° zur Austrittsoberfläche,

Ebenso ist es möglich, auf Grund der Wahl bzw. Ausgestaltung der Struktur der Lichtleitelemente die Farbtemperatur des abgestrahlten Lichts einzustellen. Vorzugsweise ist eine Einstellung der Farbtemperatur im Bereich von 3000 K - 10.000 K möglich.

Durch die erfindungsgemäße Ausgestaltung der Austrittsoberfläche mit diffraktiven Oberflächenelementen ist insbesondere eine spektrale Aufspaltung vermieden bzw. erheblich reduziert. Ferner ist eine ausreichende Lichtverstärkung bei gleichzeitig geringem Energieverbrauch gewährleistet.

Die erfindungsgemäßen diffraktiven Lichtleitelemente weisen vorzugsweise eine Größe von 0,04 µm² bis 10.000 µm², insbesondere 0,04 µm² bis 500 µm² auf. Auf Grund des Vorsehens derartig kleiner Oberflächen ist es möglich, auch bei sehr kleinen Flachbildschirmen, wie beispielsweise Displays für mobile Anwendungen, eine Vielzahl von Oberflächenelementen vorzusehen. Hierbei ist der Abstand der einzelnen Lichtleitelemente untereinander vorzugsweise im Bereich von 0 - 100 µm, insbesondere 0 - 50 µm und besonders bevorzugt 0 - 15 µm. Besonders bevorzugt ist es, dass die Lichtleitelemente einen Abstand > 0 zueinander haben. Vorzugsweise beträgt der Abstand mindestens ein 1 µm, insbesondere mindestens 3 µm. Dies hat den Vorteil, dass in Bereichen des Lichtleitkörpers, in denen mehr Licht ausgekoppelt werden soll, der Abstand der Lichtleitelemente verringert und in Bereichen, in denen eine geringere Menge an Licht ausgekoppelt werden soll, ein größerer Abstand vorgesehen werden kann. Hierdurch kann eine gute Vergleichmäßigung der Helligkeitsverteilung erzielt werden. Ferner ist es in der Herstellung einfacher, die einzelnen Lichtleitelemente stets in einem Abstand zueinander anzuordnen. Werden die Lichtleitelemente beispielsweise durch einen aushärtenden Lack in Verbindung mit einem Abformelement bzw. einem Negativ hergestellt, ist. durch das Beabstanden der Lichtleitelemente eine Verfälschung an den Grenzen der oberflächenelemente, beispielsweise durch das Entstehen von Lackstegen, vermieden. Ferner ist durch die Beabstandung der einzelnen Lichtleitelemente sichergestellt, dass Brechungen oder Verfälschungen der Beugung durch aneinander angrenzende Oberflächenstrukturen vermieden ist.

Da die einzelnen Lichtleitelemente gemäß einer bevorzugten Ausführungsform der Erfindung hinsichtlich der Höhe bzw. der Amplitude die selbe Oberflächenstruktur aufweisen, ist die Beugungseffizienz der einzelnen Lichtleitelemente identisch. Es können lediglich herstellungsbedingte Schwankungen von einigen Prozenten auftreten, die jedoch die Beugungseffizienz nur geringfügig beeinflussen.

Besonders bevorzugt ist es, die einzelnen Lichtleitelemente derart auszubilden, dass die Amplitude der unterschiedlichen Oberflächenstrukturen konstant ist und nur die Frequenz geändert ist. Je nach Art der Oberflächenstruktur, bei der es sich nicht zwingend um eine sinusförmige Oberflächenstruktur handeln muss, sind allgemein ausgedrückt sämtliche Erhöhungen gleich hoch, weisen jedoch unterschiedliche Abstände auf. Dies führt dazu, dass das von der Lichtquelle abgegebene Licht von den einzelnen Oberflächenelementen unterschiedlich gebeugt wird. Vorteilhaft ist hierbei insbesondere, dass eine Variation der Abstände einfacher herstellbar ist als variierende Höhen.

Vorzugsweise sind mehrere Lichtleitelemente mit unterschiedlichen Oberflächenstrukturen zu einer Lichtleitelemente-Gruppe zusammengefasst. Hierbei sind die unterschiedlichen Oberflächenstrukturen derart gewählt, dass von einer Lichtleitelemente-Gruppe im Wesentlichen monochromatisches und/oder weißes Licht abgegeben wird. Die Art der Oberflächenstruktur, insbesondere die durch die Oberflächenstruktur hervorgerufene Wellenlängenänderung des Lichts wird in Abhängigkeit der von der Lichtquelle abgegebenen Wellenlängenbereiche bestimmt.

Vorzugsweise umfasst eine Lichtleitelemente-Gruppe mindestens zwei Lichtleitelemente mit unterschiedlichen Oberflächenstrukturen. Vorzugsweise umfasst die Lichtleitelemente-Gruppe mindestens vier, insbesondere mindestens sechs Lichtleitelemente, die jeweils eine unterschiedliche Oberflächenstruktur aufweisen.

Da die einzelnen Lichtleitelemente gemäß einer bevorzugten Ausführungsform der Erfindung hinsichtlich der Höhe bzw. der Amplitude die selbe Oberflächenstruktur aufweisen, ist die Beugungseffektivität der einzelnen Lichtleitelemente identisch. Es können lediglich herstellungsbedingte Schwankungen von einigen Prozenten auftreten, die jedoch die Beugungseffektivität nur geringfügig beeinflussen.

Besonders bevorzugt ist es, die einzelnen Lichtleitelemente derart auszubilden, dass die Amplitude der unterschiedlichen Oberflächenstrukturen konstant ist und nur die Frequenz geändert ist. Je nach Art der Oberflächenstruktur, bei der es sich nicht zwingend um eine sinusförmige Oberflächenstruktur handeln muss, sind allgemein ausgedrückt sämtliche Erhöhungen gleich hoch, weisen jedoch unterschiedliche Abstände auf. Dies führt dazu, dass das von der Lichtquelle abgegebene Licht von den einzelnen Lichtleitelementen unterschiedlich gebeugt wird. Vorteilhaft ist hierbei insbesondere, dass eine Variation der Abstände einfacher herstellbar ist als variierende Höhen.

Die vorzugsweise in Lichtleitelemente-Gruppen angeordneten Lichtleitelemente, bei denen es sich beispielsweise um sechs Lichtleitelemente mit unterschiedlicher Oberflächenstruktur handelt, weisen vorzugsweise die selbe Amplitude von 550 nm auf. Hierbei weisen die einzelnen Lichtleitelemente einer Lichtleitelemente-Gruppe jeweils eine Frequenz von beispielsweise 490 nm, 503 nm, 517 nm, 530 nm, 575 nm und 620 nm auf. Insbesondere weisen die diffraktiven Lichtleitelemente eine sinusförmige Oberflächenstruktur auf. Der Abstand der einzelnen Lichtleitelemente untereinander liegt vorzugsweise im Bereich von 1 - 100 µm, insbesondere 1 - 50 µm und besonders bevorzugt 1-15 µm.

Nachfolgend wird die Erfindung an Hand einer bevorzugten Ausführungsform unter Bezugnahme auf die anliegenden Zeichnungen näher erläutert.

Es zeigen:
- Fig. 1: eine schematische Schnittansicht einer LED,
- Fig. 2: eine schematische Draufsicht eines Lichtleitkörpers,
- Fig. 3: eine schematische, perspektivische Ansicht eines Lichtleitelementes und
- Fig. 4: ein Beispiel einer möglichen Anordnung von Oberflächenelementen zu Oberflächenelementen-Gruppen.

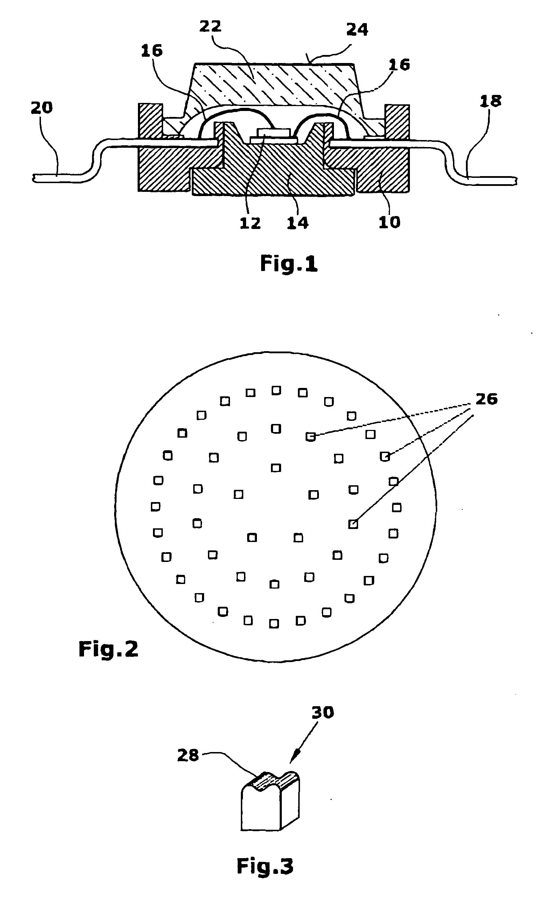

Eine LED weist einen Grundkörper 10 auf, der ein Lichterzeugungselement 12, wie einen LED-Chip, trägt. Hierzu umfasst der Grundkörper 10 ggf. zusätzlich einen Wärmeleitkörper 14 zur Kühlung des Lichterzeugungselementes 12. Das Lichterzeugungselement 12 ist über Leitungen 16 mit einer Kathode 18 und einer Anode 20 verbunden. In Abstrahlrichtung, d. h .in Fig. 1 nach oben, ist ein Lichtleitkörper 22 vorgesehen. Der Lichtleitkörper 22 ist an dem Grundkörper 10 befestigt. Auf einer Oberseite 24 des Lichtleitkörpers 22 sind diffraktive Lichtleitelemente-Gruppen 26 (Fig. 2) angeordnet.

Die erfindungsgemäß vorgesehenen diffraktiven Lichtleitelemente-Gruppen 26, die beispielsweise auf konzentrischen Kreisen auf der Oberfläche 24 vorgesehen sind, dienen zur Bestimmung des Abstrahlwinkels einer LED. Mit Hilfe entsprechend ausgebildeter und angeordneter Lichtleitelemente können geringe Abstrahlwinkel realisiert werden.

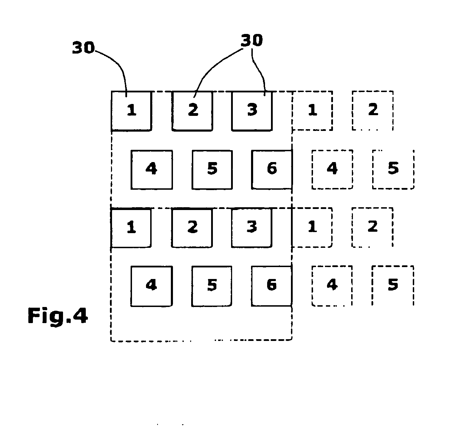

Die einzelnen Lichtleitelemente-Gruppen 26 weisen mehrere Lichtleitelemente 30 auf. In einem in Fig. 4 dargestellten Ausführungsbeispiel weist eine Lichtleitelemente-Gruppe 26 sechs Lichtleitelemente 30 auf, die zueinander vorzugsweise auf Lücke und in einem konstanten Abstand zueinander angeordnet sind. Jedes einzelne Lichtleitelement 30 weist eine unterschiedliche Oberflächenstruktur auf, so dass eine Lichtleitelemente-Gruppe 26 im Wesentlichen monochromatisches oder weißes Licht abgibt.

Zur Auskopplung von Licht unterschiedlicher Wellenlänge sind vorzugsweise unterschiedliche Lichtleitelemente 30 mit unterschiedlichen Oberflächenstrukturen angeordnet, Beispielsweise handelt es sich hierbei, wie in dem in Fig. 4 dargestellten Ausführungsbeispiel, um sechs verschiedene Lichtleitelemente 30 mit unterschiedlichen Oberflächenstrukturen 28. In Fig. 4 sind die einzelnen unterschiedlichen Lichtleitelemente 30 mit 1-6 bezeichnet. Hierbei weisen die jeweils mit der selben Ziffer bezeichneten Lichtleitelemente 30 die selbe Oberflächenstruktur auf. Vorzugsweise sind die in Fig. 3 mit 1-6 bezeichneten Lichtleitelemente 30 in einer sich wiederholenden Struktur angeordnet.

Die Oberflächenstruktur der einzelnen Oberflächenelemente ist vorzugsweise sinusförmig. Hierbei weist vorzugsweise die Amplitude 550 nm auf. Die sechs unterschiedlich ausgestalteten Lichtleitelemente 30 weisen die selbe Amplitude auf. Die einzelnen mit 1-6 bezeichneten Lichtleitelemente 39 weisen beispielsweise eine Frequenz von 490 nm, 503 nm, 517 nm, 530 nm, 575 nm und 620 nm auf. Der Abstand der einzelnen Lichtleitelemente 30 untereinander liegt vorzugsweise im Bereich von 1- 100 µm, insbesondere 1 - 50 µm und besonders bevorzugt 1 - 15 µm.

## Patentansprüche

1. Leuchtdiode, mit
einem Grundkörper,
einem von dem Grundkörper (10) getragenen Leuchtdioden-Chip (12) und
einem in Abstrahlrichtung des Leuchtdioden-Chips (12) angeordneten Lichtleitkörper (22),
**dadurch gekennzeichnet, dass**
der Lichtleitkörper (22) eine Vielzahl von diffraktiven Elementen (30) aufweist, wobei die einzelnen Elemente eine Größe von 0,04 - 10.000 µm² aufweisen.

2. Leuchtdiode nach Anspruch 1, **dadurch gekennzeichnet, dass** die Elemente (30) an einer Oberfläche (24) des Lichtleitkörpers (22) angeordnet sind.

3. Leuchtdiode nach Anspruch 2, **dadurch gekennzeichnet, dass** die Elemente (30) aus einem aushärtenden, auf die Oberfläche (24) aufgebrachten Lack hergestellt sind.

4. Leuchtdiode nach einem der Ansprüche 1 - 3, **dadurch gekennzeichnet, dass** die Elemente (30) derart angeordnet und/ oder ausgebildet sind, dass der Abstrahlwinkel der Leuchtdiode festgelegt ist.

5. Leuchtdiode nach einem der Ansprüche 1 - 4, **dadurch gekennzeichnet, dass** sämtliche Elemente (30) eine Oberflächenstruktur mit konstanter Amplitude aufweisen.

6. Leuchtdiode nach einem der Ansprüche 1 - 5, **dadurch gekennzeichnet, dass** die Elemente (30), eine Größe von 0,04 - 500 µm² aufweisen.

7. Leuchtdiode nach einem der Ansprüche 1 - 6, **dadurch gekennzeichnet, dass** die einzelnen Elemente (30) untereinander einen Abstand von 1 - 100 µm, insbesondere 1-50 µm und besonders bevorzugt 1-15 µm aufweisen.

8. Leuchtdiode nach einem der Ansprüche 1 - 7, **dadurch gekennzeichnet, dass** mehrere, vorzugsweise mindestens zwei, insbesondere mindestens vier und besonders bevorzugt mindestens sechs Elemente (30) zu einer Elemente-Gruppe (26) zusammengefasst sind.

## Claims

1. Light emitting diode comprising:
a base body,
a light diode chip (12) carried by the base body (10), and
a light guide body (22) arranged in the emitting direction of the light diode chip (12),
**characterized in that**
the light guide body (22) comprises a plurality of diffractive elements (30), the individual elements having a size between 0.04 - 10,000 µm².

2. The light diode of claim 1, **characterized in that** the elements (30) are arranged on a surface (24) of the light guide body (22).

3. The light diode of claim 2, **characterized in that** the elements (30) are made of a curing lacquer applied onto said surface (24).

4. The light diode of one of claims 1-3, **characterized in that** the elements (30) are arranged and/or configured such that the emission angle of the LED is fixed.

5. The light diode of one of claims 1-4, **characterized in that** all elements (30) have a surface structure with a constant amplitude.

6. The light diode of one of claims 1-5, **characterized in that** the elements (30) have a size between 0.04 - 500 µm².

7. The light diode of one of claims 1-6, **characterized in that** the individual elements (30) have a mutual distance of 1 - 100 µm, in particular 1-50 µm and, particularly preferred, 1-15 µm.

8. The light diode of one of claims 1-7, **characterized in that** a plurality, preferably at least two, especially at least four and most preferred at least six elements (30) are comprised in a group (26) of elements.

## Revendications

1. Diode électroluminescente comprenant
un corps de base,
une puce de diode électroluminescente (12) supportée par ledit corps de base (10), et
un corps photoconducteur (22) disposé dans la direction d'émission de ladite puce de diode électroluminescente (12),
**caractérisée en ce que**
ledit corps photoconducteur (22) comprend plusieurs éléments diffractifs (30), lesdits éléments individuels comprenant une grandeur entre 0,04 - 10,000 µm².

2. Diode électroluminescente selon la revendication 1, **caractérisée en ce que** lesdits éléments (30) sont disposés sur une surface (24) dudit corps photoconducteur (12).

3. Diode électroluminescente selon la revendication 2, **caractérisée en ce que** lesdits éléments (30) sont fabriqués d'une laque durcissante appliquée sur ladite surface (24).

4. Diode électroluminescente selon l'une quelconque des revendications 1 à 3, **caractérisée en ce que** lesdits éléments (30) sont disposés et/ou configurés de manière à ce que l'angle d'émission de la diode électroluminescente soit fixe.

5. Diode électroluminescente selon l'une quelconque des revendications 1 à 4, **caractérisée en ce que** tous les éléments (30) comprend une structure de surface avec une amplitude constante.

6. Diode électroluminescente selon l'une quelconque des revendications 1 à 5, **caractérisée en ce que** la grandeur des éléments (30) est entre 0,04 - 500 µm².

7. Diode électroluminescente selon l'une quelconque des revendications 1 à 6, **caractérisée en ce que** les éléments (30) individuels sont écartés l'un de l'autre par 1 - 100 µm, particulièrement 1-50 µm, et plus préféré 1-15 µm.

8. Diode électroluminescente selon l'une quelconque des revendications 1 à 7, **caractérisée en ce que** plusieurs, de préférence au moins deux, particulièrement au moins quatre et plus préféré au moins six éléments (30) sont compris dans un groupe d'éléments (26).
